# EUROPEAN PATENT APPLICATION

(11) **EP 4 815 305 A1**
(43) Date of publication of application: **30.09.2026**
(21) Application number: 25216352.2
(22) Date of filing: 17.11.2025
(51) Int. Cl.: H03K 17/0412, H03K 17/081, H03K 17/16, H10D 1/43, H10D 8/00, H10D 8/60, H10D 84/03, H10D 84/00

(54) **TRANSISTOR WITH ASYMMETRIC GATE RESISTANCE SCHEME**

(30) Priority: 24.03.2025 US 202519087988
(71) Applicant: Semiconductor Components Industries, LLC, Scottsdale, AZ 85250 (US)
(72) Inventor: DOMEIJ, Martin, 19139 Sollentuna, Stockholm (SE); FRANCHI, Jimmy Robert Hannes, 74598 Enköping, Uppland (SE); ROIG-GUITART, Jaume, 9700 Oudenaarde, Flanders (BE)
(74) Representative: Manitz Finsterwald Patent- und Rechtsanwaltspartnerschaft mbB

(57) **Abstract**

A switch circuit is disclosed. The switch circuit comprises a transistor including a gate, a source, and a drain, wherein the transistor is included within an integrated circuit package. The switch circuit also includes a charge path coupled between a gate input of the integrated circuit package and the gate of the transistor. The switch circuit further includes a discharge path coupled between the gate input of the integrated circuit package and the gate of the transistor. The charge path and the discharge path have an asymmetric impedance.

## Description

### TECHNICAL FIELD

The disclosure relates generally to integrated circuit technology, and particularly to switching circuits.

### BACKGROUND

Power electronics may be used to control the conversion and distribution of electric power. For example, switching power converters may be used to create a direct current ("DC") voltage from an alternating current ("AC") voltage by switching current through a magnetic element such as an inductor or a winding of a transformer. Conversely, inverters can be used to convert a DC voltage to an AC voltage. In these and other forms of power electronics, power transistors may be used to control the conversion and flow of power through the power-conversion system and to the electronic circuitry to be powered by the device.

In certain power converter applications, the power transistors utilized therein may be required to survive for a given short-circuit withstand time (SCWT) value. For example, to ensure robust design, the power transistors in a power converter must be able to survive a short-circuit condition for a given time period. Inventors of embodiments of the present disclosure have recognized that during such short-circuit conditions, oscillations at the gate of a power transistor may be caused by parasitic inductances and capacitances coupled to or incurred at the gate of the transistor. Inventors of embodiments of the present disclosure have also recognized that such oscillations may grow, ultimately causing destruction of the transistor before the desired SCWT value. Embodiments of the present disclosure may address one or more of these challenges.

### SUMMARY

According to one embodiment, a switch circuit includes (i) a transistor having a gate, a source, and a drain, the transistor included within an integrated circuit package, (ii) a charge path coupled between a gate input of the integrated circuit package and the gate of the transistor, and (iii) a discharge path coupled between the gate input of the integrated circuit package and the gate of the transistor, wherein the charge path and the discharge path have an asymmetric impedance. In some embodiments, the wherein the transistor is a silicon carbide transistor.

In the same or different embodiments, the charge path includes a charge-path diode coupled in series with a charge-path resistor. In the same or different embodiments, the discharge path includes a discharge-path resistor. In the same or different embodiments, a discharge-path resistance of the discharge-path resistor is greater than a charge-path resistance of the charge-path resistor. In the same or different embodiments, the discharge path further includes a discharge-path diode coupled in series with the discharge-path resistor.

According to another embodiment, a driver system includes a driver circuit, a drive path coupled to an output of the driver circuit, and at least one switch circuit coupled to be driven by the driver circuit via the drive path, wherein each of the at least one switch circuit comprise (i) a transistor including a gate, a source, and a drain, the transistor included within an integrated circuit package, (ii) a charge path coupled between a gate input of the integrated circuit package and the gate of the transistor, and (iii) a discharge path coupled between the gate input of the integrated circuit package and the gate of the transistor, wherein the charge path and the discharge path have an asymmetric impedance. In some embodiments, wherein the transistor is a silicon carbide transistor. In the same or different embodiments, the drive path includes a drive-path resistor. In the same or different embodiments, the drive path includes a charge branch and a discharge branch coupled in parallel to each other. In the same or different embodiments, the charge branch includes a charge-branch diode coupled in series with a charge-branch resistor. In the same or different embodiments, the discharge branch includes a discharge-branch resistor. In the same or different embodiments, a discharge-branch resistance of the discharge-branch resistor is greater than a charge-branch resistance of the charge-branch resistor. In the same or different embodiments, the discharge branch further includes a discharge-branch diode coupled in series with the discharge-branch resistor. In the same or different embodiments, the charge path includes a charge-path diode coupled in series with a charge-path resistor. In the same or different embodiments, the discharge path includes a discharge-path resistor. In the same or different embodiments, a discharge-path resistance of the discharge-path resistor is greater than a charge-path resistance of the charge-path resistor. In the same or different embodiments, the discharge path further includes a discharge-path diode coupled in series with the discharge-path resistor.

According to another embodiment, a switch circuit includes (i) a transistor including a gate, a source, and a drain, the transistor included within an integrated circuit package, (ii) a charge path coupled between a gate input of the integrated circuit package and the gate of the transistor, the charge path including a charge-path diode coupled in series with a charge-path resistor, and (iii) a discharge path coupled between the gate input of the integrated circuit package and the gate of the transistor, the discharge path including a discharge-path resistor, wherein a discharge-path resistance of the discharge-path resistor is greater than a charge-path resistance of the charge-path resistor. In some embodiments, the transistor is a silicon carbide transistor.

### BRIEF DESCRIPTION OF THE DRAWINGS

A more complete understanding of the present embodiments may be acquired by referring to the following description taken in conjunction with the accompanying drawings, in which like reference numbers indicate like features.
FIG. 1 illustrates a schematic diagram of a transistor driver system.
FIG. 2 illustrates a schematic diagram of a transistor driver system in accordance with embodiments of the present disclosure.
FIG. 3 illustrates a schematic diagram of a transistor driver system in accordance with embodiments of the present disclosure.
FIG. 4 illustrates a schematic diagram of a transistor driver system in accordance with embodiments of the present disclosure.
FIG. 5A illustrates a schematic diagram of a transistor driver system in accordance with embodiments of the present disclosure.
FIG. 5B illustrates a perspective view of a multi-die switch circuit in accordance with embodiments of the present disclosure.
FIG. 6A illustrates a top layout view of charge path for a gate of a transistor in accordance with embodiments of the present disclosure.
FIG. 6B illustrates a side cross-section view of a charge path for a gate of a transistor in accordance with embodiments of the present disclosure.
FIG. 6C illustrates a top layout view of discharge path for a gate of a transistor in accordance with embodiments of the present disclosure.
FIG. 6D illustrates a side cross-section view of a discharge path for a gate of a transistor in accordance with embodiments of the present disclosure.
FIG. 7A illustrates a top layout view of charge path for a gate of a transistor in accordance with embodiments of the present disclosure.
FIG. 7B illustrates a side cross-section view of a charge path for a gate of a transistor in accordance with embodiments of the present disclosure.
FIG. 7C illustrates a top layout view of a discharge path for a gate of a transistor in accordance with embodiments of the present disclosure.
FIG. 7D illustrates a side cross-section view of a discharge path for a gate of a transistor in accordance with embodiments of the present disclosure.
FIG. 8A illustrates a top layout view of charge path for a gate of a transistor in accordance with embodiments of the present disclosure.
FIG. 8B illustrates a side cross-section view of a charge path for a gate of a transistor in accordance with embodiments of the present disclosure.
FIG. 8C illustrates a top layout view of discharge path for a gate of a transistor in accordance with embodiments of the present disclosure.
FIG. 8D illustrates a side cross-section view of a discharge path for a gate of a transistor in accordance with embodiments of the present disclosure.

### DETAILED DESCRIPTION

Details of one or more embodiments are set forth in the description below and the accompanying drawings. Other features will be apparent from the description, drawings, and from the claims. The embodiments disclosed should not be interpreted, or otherwise used, as limiting the scope of the disclosure, including the claims. In addition, one skilled in the art understands that the following description has broad application, and the discussion of any embodiment is meant to be exemplary of that embodiment, and not intended to intimate that the scope of the disclosure, including the claims, is limited to that embodiment.

Various terms are used to refer to particular system components. Different companies may refer to a component by different names, and this disclosure does not intend to distinguish between components that differ in name but not form and function. In the following discussion and in the claims, the terms "including" and "comprising" are used in an open-ended fashion, and thus should be interpreted to mean "including, but not limited to." Also, the term "couple" or "coupled" is intended to mean either an indirect or direct connection. Thus, if a first device couples to, or is coupled to, a second device, that connection between the first device and the second device may be through a direct connection or through an indirect connection via other devices and connections.

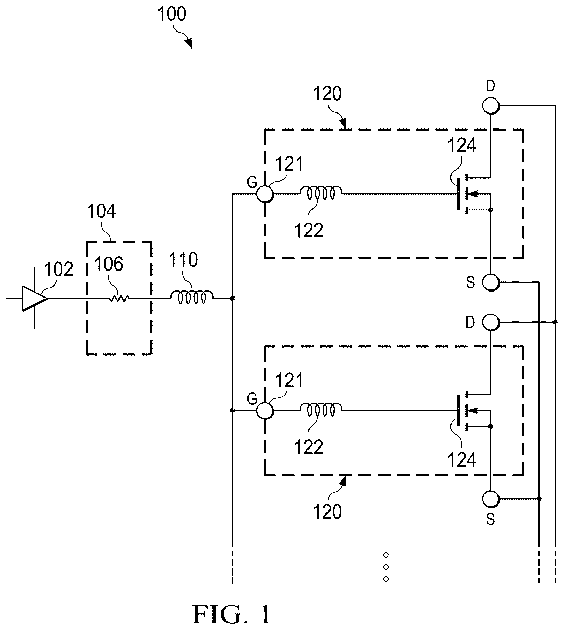

FIG. 1 illustrates a schematic diagram of transistor driver system 100. Transistor driver system 100 may include driver circuit 102, drive path 104, and a plurality of transistors 124 coupled in parallel to each other. In some embodiments, transistor driver system 100 may form part of a power converter circuit, such as a traction inverter. For example, the plurality of transistors 124 coupled in parallel to each other may form the high-side or low-side transistors of an H-bridge configured to drive one phase of a three-phase traction inverter. Further instances of transistor 124 and/or transistor driver system 100 may be utilized to form the complete inverter system.

As shown in FIG. 1, drive path 104 may include drive-path resistor 106. Drive-path resistor 106 may have a value selected to control the turn-on transition time and the turn-off transition time of the plurality of transistor 124. For example, a higher resistance value for drive-path resistor 106 may provide for a slower turn-on transition time and a slower turn-off transition time for each instance of transistor 124 in response to a drive signal from driver circuit 102. Likewise, a lower resistance value for drive-path resistor 106 may provide for a faster turn-on transition time and a faster turn-off transition time for each instance of transistor 124 in response to a drive signal from driver circuit 102.

In addition to drive path 104, the path from driver circuit 102 to the respective gates of the plurality of transistors 124 may include various parasitics. For example, each instance of transistor 124 may be included within an integrated circuit package 120. Inductor 110 may represent the parasitic inductance of the routing between the output of driver circuit 102 and gate input 121 of integrated circuit package 120. Such parasitic inductance represented by inductor 110 may include, for example, the parasitic inductance of metal lines on a printed circuit board (PCB) coupling the output of driver circuit 102 and/or drive path 104 to gate input 121 of integrated circuit package 120. Inductor 122 may represent the parasitic inductance of the wiring between the gate input 121 of integrated circuit package 120 and the gate of transistor 124. For example, inductor 122 may include the parasitic inductance of bond wiring from a lead frame of integrated circuit package 120 to a gate pad on the die on which transistor 124 is implemented. Inductor 122 may further include the parasitic inductance of any metal routing from such a gate pad to the physical gate of transistor 124.

Inventors of embodiments of the present disclosure have recognized that in certain power applications, such as transistor driver system 100, where multiple instances of transistor 124 may be coupled together in parallel, the multiple parallel devices may form an L-C tank susceptible to oscillations. For example, each instance of integrated circuit package 120 may include an internal parasitic inductance represented by inductor 122 coupled in series to the parasitic gate capacitance of transistor 124. Thus, by coupling the respective gate inputs 121 of multiple instances of integrated circuit package 120 together, a parasitic L-C tank may be formed. In other examples, even where only a single instance of transistor 124 is included in transistor driver system 100, the parasitic inductance of represented by inductor 122 and the gate capacitance of transistor 124 may combine with other external parasitics to form an L-C tank susceptible to oscillations under certain conditions.

The oscillations described directly above may cause damage to one or more components, including transistor 124, of the system in which transistor driver system 100 is implemented under certain system level conditions. For example, system specifications may require that a transistor such as transistor 124 may be required to withstand a short-circuit condition for a given time period. As one example, when implemented as part of a high-side or a low-side drive for one phase of a traction inverter, a transistor such as transistor 124 may be required by system specifications to withstand a short-circuit condition whereby both the high-side and the low-side drives are mistakenly turned on at the same time for a given period of time. Such a short-circuit condition may occur for example if the high-side is turned on before the low-side is turned off in a given switching cycle. During such short-circuit conditions, oscillations at the gate of transistor 124 may cause the drain current and/or the drain voltage of transistor 124 to also oscillate. As the oscillations magnify and grow, the drain to source voltage may surpass the breakdown voltage of transistor 124, thereby causing an avalanche breakdown. Alternatively or in addition, the oscillation of the gate-to-source voltage may reach a high amplitude causing a breakdown and failure of the gate oxide. Accordingly, such oscillations may reduce the short-circuit withstand time (SCWT) that transistor 124 would otherwise have based on its voltage stand-off and current handling capability absent the oscillations. As described in further detail below, embodiments disclosed herein may include an asymmetric drive path internal to the integrated circuit package in which a transistor, such as transistor 124, is included in order to attenuate such oscillations and thereby improve the short-circuit withstand time of the transistor.

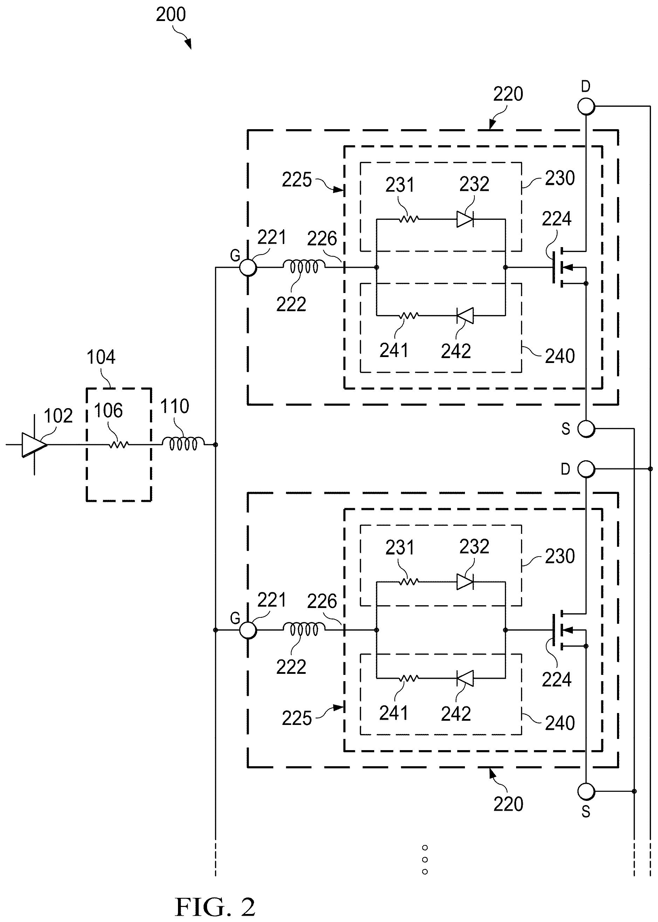

FIG. 2 illustrates a schematic diagram of transistor driver system 200 in accordance with embodiments of the present disclosure. Transistor driver system 200 may be implemented in any suitable fashion according to the operation described in the present disclosure. As shown in FIG. 2, transistor driver system 200 may include driver circuit 102. Transistor driver system 200 may also include drive path 104 coupled to an output of driver circuit 102. Further, transistor driver system 200 may include at least one switch circuit 225 to be driven by driver circuit 102 via drive path 104. For example, driver circuit 102 may receive an input signal and in response to the input signal, provide an output signal for driving the respective transistors 224 of one or more instances of switch circuit 225 in a conductive on-state or in a non-conductive off-state.

In some embodiments, drive path 104 may include a resistor such as drive-path resistor 106. Drive-path resistor 106 may have a value selected to help control the turn-on transition time and the turn-off transition time of the plurality of transistor 224. For example, a higher resistance value for drive-path resistor 106 may provide for a slower turn-on transition time and a slower turn-off transition time for each instance of transistor 224 in response to a drive signal from driver circuit 102. Likewise, a lower resistance value for drive-path resistor 106 may provide for a faster turn-on transition time and a faster turn-off transition time for each instance of transistor 224 in response to a drive signal from driver circuit 102. In some embodiments, drive-path resistor 106 may have a resistance value of, for example, 1, 2, 4, 10, 20, or more Ohms, depending on the number and size of transistors 224 to be driven and the desired turn-on and turn-off transition times. Although the embodiment illustrated in FIG. 2 illustrates drive path 104 as including drive-path resistor 106, in some embodiments, a resistance value of zero may be selected. In such embodiments, drive path 104 may be a simple wired connection directly to the integrated circuit package 220 in which switch circuit 225 and transistor 224 are implemented.

In some embodiments, drive path 104, including for example drive-path resistor 106, may be external to the integrated circuit package 220 in which transistor 224 and other components of switch circuit 225 may be included. Accordingly, the components and component values for drive path 104, for example the selection of a resistance value for drive-path resistor 106, may represent a board-level design option allowing tuning of the turn-on transition and turn-off transition of transistor 224 according to system-level design requirements.

In addition to drive path 104, the path between driver circuit 102 to the respective gates of the plurality of transistors 224 may include various parasitics. For example, each instance of transistor 224 may be included within an integrated circuit package 220. Inductor 110 may represent the parasitic inductance of the routing between the output of driver circuit 102 and gate input 221 of integrated circuit package 220. Such parasitic inductance represented by inductor 110 may include, for example, the parasitic inductance of metal lines on a printed circuit board (PCB) coupling the output of driver circuit 102 and/or drive path 104 to gate input 221 of integrated circuit package 220. Inductor 222 may represent the parasitic inductance of the routing between the gate input 221 of integrated circuit package 220 and the gate input 226 of switch circuit 225. For example, integrated circuit package 220 may include a bond wire coupling gate input 221 at the lead frame of integrated circuit package 220 to the gate input 226 of switch circuit 225 within integrated circuit package 220. Inductor 222 may represent the parasitic inductance of such bond wiring and/or further on-chip metal routing to components of switch circuit 225. As described below, switch circuit 225 may be configured with a charge path and a discharge path that have an asymmetric impedance to dampen or prevent oscillations that may otherwise occur under certain system conditions due to internal parasitics, such as the parasitic inductance represented by inductor 222 and the gate capacitance of transistor 224. Such asymmetric impedance may provide dampening to prevent or limit such oscillations without significantly increasing switching loss.

As shown in FIG. 2, switch circuit 225 may include transistor 224. In some embodiments, transistor 224 may be a metal-oxide semiconductor field effect transistor (MOSFET) and may thus have a gate, a source, and a drain. In some embodiments, transistor 224 may specifically be for example an n-channel MOSFET (NMOS or NMOS transistor). Transistor 224 may be implemented with any suitable semiconductor material. In some embodiments, transistor 224 may be a silicon carbide transistor, or specifically an silicon carbide NMOS transistor. Transistor 224 may also be implemented with silicon, gallium nitride, or any other semiconductor material suitable to manufacture a power transistor.

Switch circuit 225 may also include charge path 230 coupled between gate input 226 of switch circuit 225 and the gate of transistor 224. As shown in FIG. 2 and described above, the gate input 226 of switch circuit 225 may be coupled to gate input 221 of integrated circuit package 220, where inductor 222 represents the parasitic inductance of such coupling, for example through bond wires or other intra-package routing. Thus, charge path 230 may also be referred to as a charge path coupled between gate input 221 of integrated circuit package 220 and the gate of transistor 224. In addition, switch circuit 225 may include a discharge path 240 coupled in parallel to charge path 230. As shown in FIG. 2, discharge path 240 may be coupled between gate input 226 of switch circuit 225 and the gate of transistor 224. Discharge path 240 may also be referred to as a discharge path coupled between gate input 221 of integrated circuit package 220 and the gate of transistor 224. As described below, this charge path 230 and discharge path 240 may have an asymmetric impedance.

In some embodiments, charge path 230 may include charge-path diode 232 coupled in series with charge-path resistor 231. For example, as shown in FIG. 2, charge-path resistor 231 may be coupled between gate input 226 and the anode of charge-path diode 232, whose cathode may in turn be coupled to the gate of transistor 224. In some embodiments, the order of charge-path resistor 231 and charge-path diode 232 may be switched relative to the order shown in FIG. 2, but with the cathode of charge-path diode 232 still pointing toward the gate of transistor 224. Accordingly, charge path 230 may provide a path for a turn-on signal from driver circuit 102 to charge the gate of transistor 224, thereby increasing the voltage at the gate of transistor 224, and driving transistor 224 in a conductive on-state. Charge-path diode 232 may however block any discharge current flowing away from the gate of transistor 224 through charge path 230. Such discharge current may instead pass through discharge path 240 as described below.

In some embodiments, discharge path 240 may include discharge-path diode 242 coupled in series with discharge-path resistor 241. For example, as shown in FIG. 2, discharge-path resistor 241 may be coupled between gate input 226 and the cathode of discharge-path diode 242, whose anode may in turn be coupled to the gate of transistor 224. In some embodiments, the order of discharge-path resistor 241 and discharge-path diode 242 may be switched relative to the order shown in FIG. 2, but with the cathode of discharge-path diode 242 still pointing away from the gate of transistor 224. Accordingly, discharge path 240 may provide a path for a turn-off signal from driver circuit 102 to discharge the gate of transistor 224, thereby decreasing the voltage at the gate of transistor 224, and driving transistor 224 in a non-conductive off-state. Discharge-path diode 242 may however block any charge current flowing toward the gate of transistor 224 through discharge path 240. Such charge current may instead pass through charge path 230 as described above.

The discharge-path resistance of discharge-path resistor 241 may be greater than the charge-path resistance of charge-path resistor 231. Accordingly, charge path 230 and discharge path 240 may have an asymmetric impedance. In some embodiments, the discharge-path resistance of discharge-path resistor 241 may be greater than the charge-path resistance of charge-path resistor 231 by a ratio of, for example, 2:1, 3:1, 4:1, 5:1, 10:1, or more. For example, in some embodiments charge-path resistor 231 may have a resistance of 0.1, 0.25, 0.5, 1.0, 1.5, 2, 4, or more Ohms, while discharge-path resistor 241 may have a resistance that is 2, 3, 4, 5, 10, or more times greater than the resistance of charge-path resistor 231. Further, in some embodiments, drive-path resistor 106 of drive path 104 may have a greater resistance than charge-path resistor 231 and/or discharge-path resistor 241.

The asymmetric impedance of charge path 230 and discharge path 240 may provide multiple benefits, including reducing or eliminating potentially harmful oscillations and also reducing switching losses. As described above, the internal parasitic inductance (represented by inductor 222) and the internal parasitic gate capacitance of transistor 224 may form an LC-tank with other circuitry, such as another parallel instance of switch circuit 225, susceptible to oscillations under certain conditions. The larger resistance of discharge-path resistor 241 may provide larger dampening for any such oscillations, thereby reducing or eliminating such oscillations and/or negative effects thereof. Further, the smaller resistance of charge-path resistor 231 may reduce turn-on switching losses. For example, resistance in the charge and/or discharge path of the gate of transistor 224 may contribute to switching losses, which is the energy required to turn transistor 224 on and off. Given the Miller effect of the parasitic gate-to-drain capacitance of transistors such as transistor 224, the switching loss during the turn-on transition may be larger than the switching loss during the turn-off transition. Thus, by keeping the resistance of charge-path resistor 231 smaller than the resistance of discharge-path resistor 241, switching losses may be reduced.

In some embodiments, drive path 104 and the components included therein such as drive-path resistor 106, may be external to the integrated circuit package 220 in which transistor 224 and other components of switch circuit 225 may be included. Accordingly, the components and component values for drive path 104 may represent a board-level design option allowing tuning of the turn-on transition and turn-off transition of transistor 224 according to system-level design requirements. For example, the turn-on transition time for transistor 224 may depend on both the resistance of drive-path resistor 106 external to integrated circuit package 220 and the resistance of charge-path resistor 231 internal to switch circuit 225 within integrated circuit package 220. Likewise, the turn-off transition time for transistor 224 may depend on both the resistance of drive-path resistor 106 external to integrated circuit package 220 and the resistance of discharge-path resistor 241 internal to switch circuit 225 and integrated circuit package 220. Accordingly, the selection of resistance values for charge-path resistor 231 and discharge-path resistor 241 may represent on-chip design options for contributing to the turn-on and turn-off transition times as well as for dampening oscillations as described above for example during short-circuit conditions. Although drive-path resistor 106 may be located outside of the resonating loop for the oscillations described above and may thus have no dampening effect on such oscillations, the selection of the resistance value for drive-path resistor 106 may represent board-level design options for controlling the turn-on and turn-off transition times.

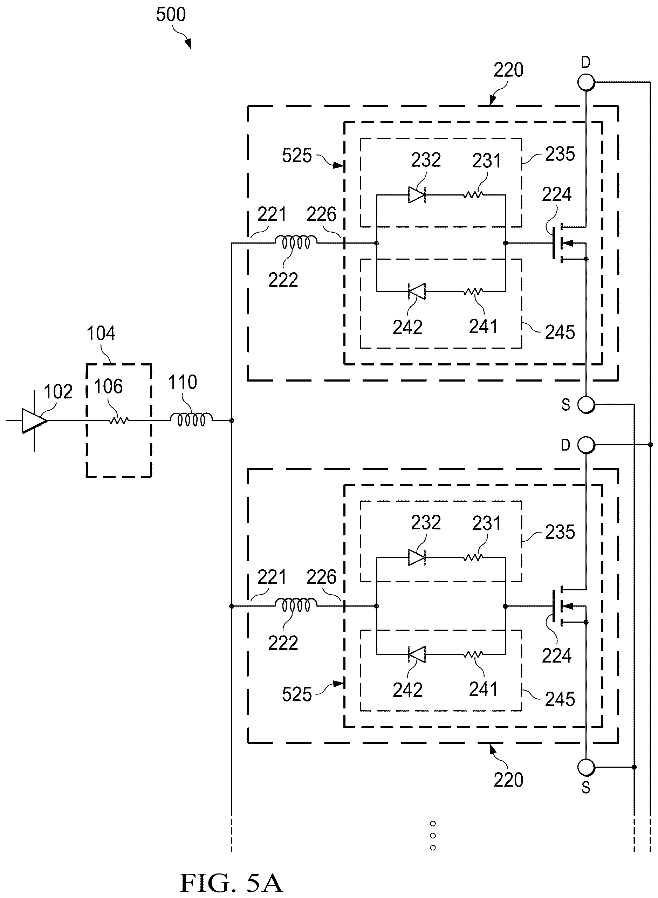

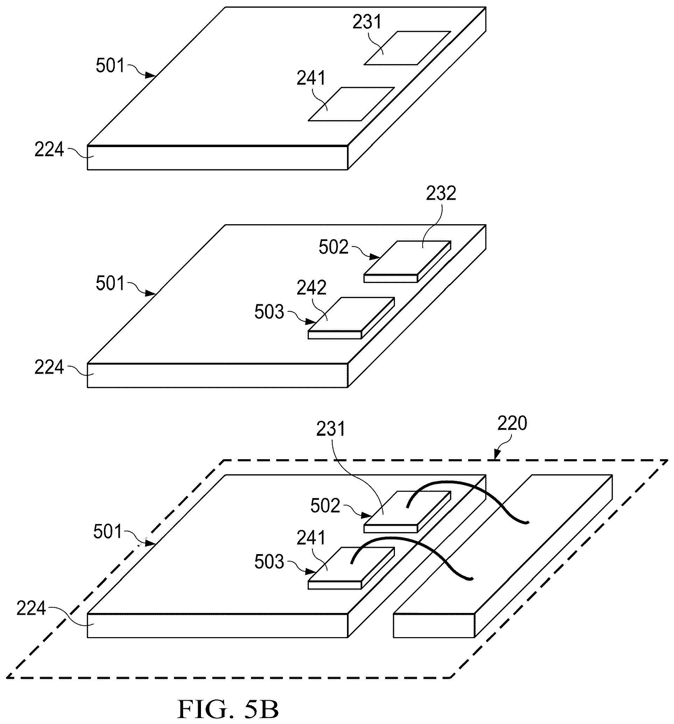

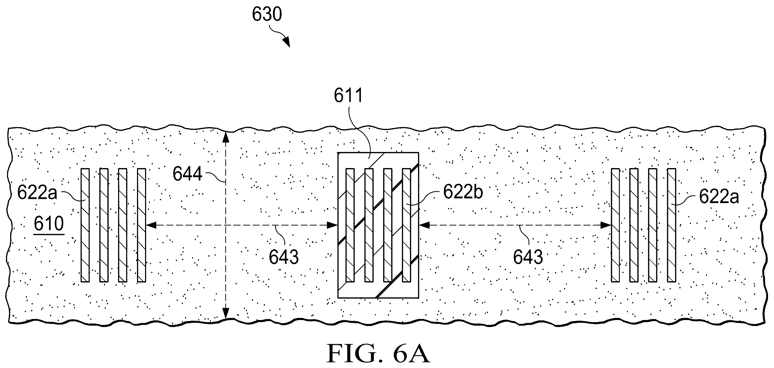

In some embodiments, transistor 224 may be monolithically integrated with one or more components of charge path 230 and/or discharge path 240. For example, transistor 224, charge-path resistor 231, charge-path diode 232, discharge-path resistor 241, and discharge-path diode 242 may be monolithically integrated on the same semiconductor die included within integrated circuit package 220. In other embodiments, various components of charge path 230 and discharge path 240 may be included on one or more dies separate from the semiconductor die of transistor 224 but co-packaged with transistor 224 within integrated circuit package 220. Example embodiments utilizing multi-die and/or multi-component co-packaging are described below with reference to FIG. 5A and FIG. 5B. In addition, examples of monolithic integration of resistors and diodes to monolithically form a charge path and/or a discharge path on the same semiconductor die as transistor 224 are described below with reference to FIGS. 6A-6D, 7A-7D, and 8A-8D.

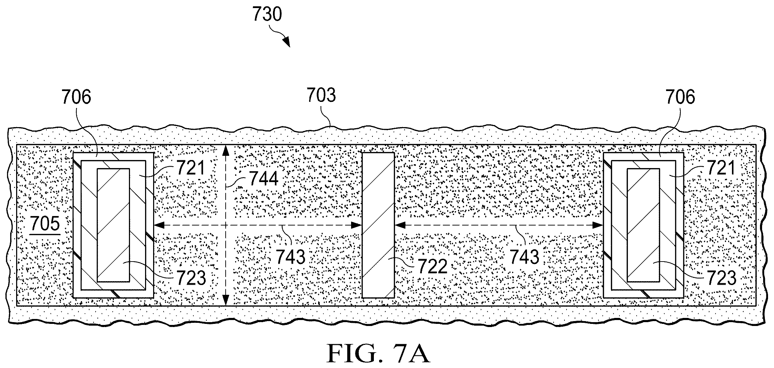

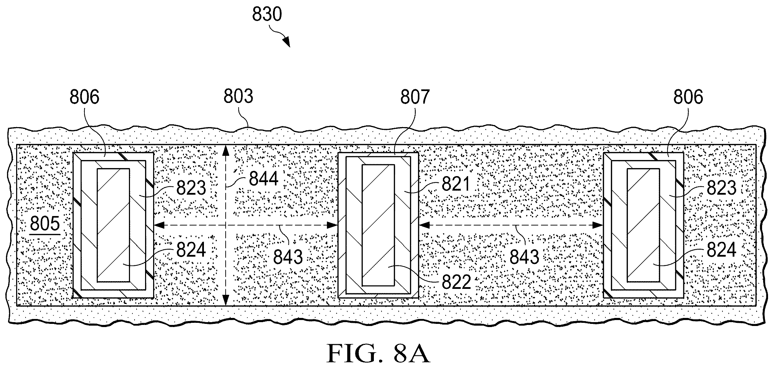

In some embodiments, charge-path diode 232 and/or discharge-path diode 242 may be diode-connected transistors. For example, charge-path diode 232 and discharge-path diode 242 may be formed by coupling the gate and drain of an NMOS transistor together, whereby the gate and drain collectively serve as the anode of the diode and the source of the NMOS transistor serves as the cathode. In other embodiments, charge-path diode 232 and discharge-path diode 242 may be implemented for example as polysilicon p-n diodes (as described below with reference to FIGS. 6A-6D), Schottky diodes (as described below with reference to FIGS. 7A-7D), or p-n semiconductor diodes (as described below with reference to FIGS. 8A-8D).

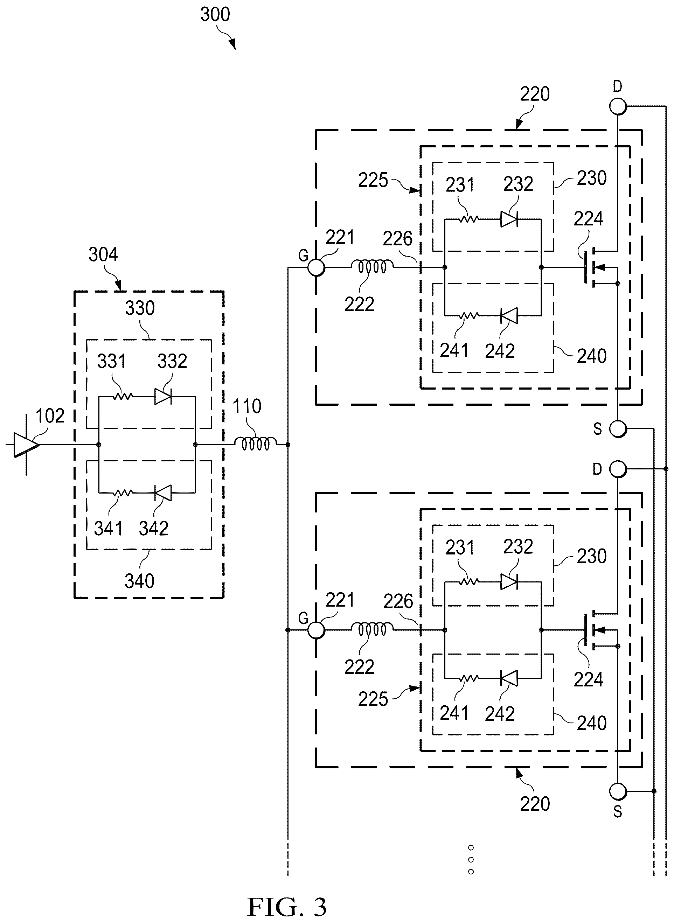

FIG. 3 illustrates a schematic diagram of transistor driver system 300 in accordance with embodiments of the present disclosure. Transistor driver system 300 may be implemented in any suitable fashion according to the operation described in the present disclosure. Transistor driver system 300 may represent an alternative embodiment to transistor driver system 200. For example, similar to transistor driver system 200 shown in FIG. 2, transistor driver system 300 shown in FIG. 3 may include driver circuit 102 and one or more instances of switch circuit 225 coupled in parallel to each other and driven by driver circuit 102. Driver circuit 102, and switch circuit 225, as well as the components of switch circuit 225 including transistor 224, charge path 230 and discharge path 240, may be implemented and/or may operate in a similar manner as described above with reference to FIG. 2. As shown in FIG. 3, transistor driver system 300 may also include drive path 304.

Drive path 304 may be coupled to the output of driver circuit 102 and may pass drive signals for driving one or more instances of switch circuit 225 to the respective gate inputs 226 of switch circuits 225. For example, in some embodiments, drive path may include charge branch 330 and discharge branch 340 coupled in parallel to each other between the output of driver circuit 102 and the respective gate inputs 226 of one or more instances of switch circuit 225.

In some embodiments, charge branch 330 may include charge-branch diode 332 coupled in series with charge-branch resistor 331. For example, as shown in FIG. 3, charge-branch resistor 331 may be coupled between the output of driver circuit 102 and the anode of charge-branch diode 332, whose cathode may in turn be coupled to the gate input 226 of switch circuit 225 via the gate input 221 of integrated circuit package 220. In some embodiments, the order of charge-branch resistor 331 and charge-branch diode 332 may be switched relative to the order shown in FIG. 3, but with the cathode of charge-branch diode 332 still pointing toward the gate input 226 of switch circuit 225. Accordingly, charge branch 330 may provide a path through drive path 304 for a turn-on signal from driver circuit 102 that may charge the gate of transistor 224, thereby increasing the voltage at the gate of transistor 224, and driving transistor 224 in a conductive on-state. Charge-branch diode 332 may however block any discharge current flowing away from the gate of transistor 224 through charge branch 330. Such discharge current may instead pass through discharge branch 340 as described below.

In some embodiments, discharge branch 340 may include discharge-branch diode 342 coupled in series with discharge-branch resistor 341. For example, as shown in FIG. 3, discharge-branch resistor 341 may be coupled between the output of driver circuit 102 and the cathode of discharge-branch diode 342, whose anode may in turn be coupled to the gate input 226 of switch circuit 225 via the gate input 221 of integrated circuit package 220. In some embodiments, the order of discharge-branch resistor 341 and discharge-branch diode 342 may be switched relative to the order shown in FIG. 3, but with the cathode of discharge-branch diode 342 still pointing away from the gate of transistor 224. Accordingly, discharge branch 340 may provide a path through drive path 304 for a turn-off signal from driver circuit 102 to discharge the gate of transistor 224, thereby decreasing the voltage at the gate of transistor 224, and driving transistor 224 in a non-conductive off-state. Discharge-branch diode 342 may however block any charge current flowing toward the gate of transistor 224 through discharge branch 340. Such charge current may instead pass through charge branch 330 as described above.

In some embodiments, drive path 304 and the components included therein, may be external to the integrated circuit package 220 in which transistor 224 and other components of switch circuit 225 may be included. Accordingly, the components and component values for drive path 304 may represent a board-level design option allowing tuning of the turn-on transition and turn-off transition of transistor 224 according to system-level design requirements. For example, the turn-on transition time for transistor 224 may depend on both the resistance of charge-branch resistor 331 external to integrated circuit package 220 and the resistance of charge-path resistor 231 internal to switch circuit 225 within integrated circuit package 220. Likewise, the turn-off transition time for transistor 224 may depend on both the resistance of discharge-branch resistor 341 external to integrated circuit package 220 and the resistance of discharge-path resistor 241 internal to switch circuit 225 and integrated circuit package 220. Accordingly, the selection of resistance values for charge-path resistor 231 and discharge-path resistor 241 may represent on-chip design options for contributing to the turn-on and turn-off transition times as well as for dampening oscillations as described above, for example during short-circuit conditions. Although charge-branch resistor 331 and discharge-branch resistor 341 may be located outside of the resonating loop and thus may not impact the oscillations described above, the selection of resistance values for charge-branch resistor 331 and discharge-branch resistor 341 may represent board-level design options for controlling the turn-on and turn-off transition times.

In some embodiments, the discharge-branch resistance of discharge-branch resistor 341 may be greater than a charge-branch resistance of charge-branch resistor 331. In other embodiments, the discharge-branch resistance of discharge-branch resistor 341 may be less than or equal to the charge-branch resistance of charge-branch resistor 331, depending on the system-level requirements for the turn-on and turn-off transition times respectively, as well as other considerations such as switching loss incurred during the turn-on and turn-off transitions. And in some embodiments, one or both of charge-branch resistor 331 and discharge-branch resistor 341 may have a larger resistance than charge-path resistor 231 and/or discharge-path resistor 241.

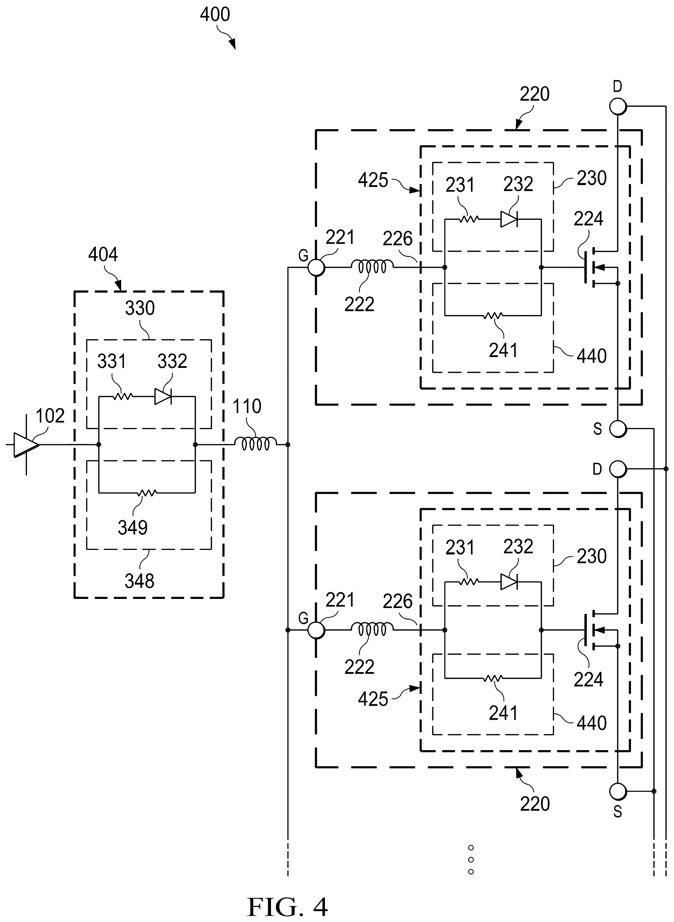

FIG. 4 illustrates a schematic diagram of transistor driver system 400 in accordance with embodiments of the present disclosure. Transistor driver system 400 may be implemented in any suitable fashion according to the operation described in the present disclosure. The embodiment of transistor driver system 400 illustrated in FIG. 4 may operate in a similar manner to transistor driver system 300 described above with reference to FIG. 3. As described below, transistor driver system 400 may omit a discharge-path diode from the discharge path 440 of switch circuit 425. Likewise, transistor driver system 400 may omit a discharge-branch diode from discharge branch 348 of drive path 404.

As shown in FIG. 4, transistor driver system 400 may include one or more instances of switch circuit 425 coupled in parallel to each other, and to be driven by driver circuit 102 via drive path 404. In some embodiments, switch circuit 425 may be included within integrated circuit package 220 in a similar manner as described above for switch circuit 225 with reference to FIG. 2 and FIG. 3. Switch circuit 425 may include charge path 230 coupled in parallel to discharge path 440 between gate input 226 of switch circuit 425 and the gate of transistor 224. As described above, charge path 230 may include charge-path diode 232 coupled in series with charge-path resistor 231, with the cathode of charge-path diode 232 pointing toward the gate of transistor 224. Accordingly, charge path 230 may provide a path for a turn-on signal from driver circuit 102 to charge the gate of transistor 224, thereby increasing the voltage at the gate of transistor 224, and driving transistor 224 in a conductive on-state.

Discharge path 440 may include discharge-path resistor 241. In some embodiment, the discharge-path resistance of discharge-path resistor 241 may be greater than the charge-path resistance of charge-path resistor 231. Accordingly, charge path 230 and discharge path 440 may have an asymmetric impedance. In some embodiments, the discharge-path resistance of discharge-path resistor 241 may be greater than the charge-path resistance of charge-path resistor 231 by a ratio of, for example, 2:1, 3:1, 4:1, 5:1, 10:1, or more. For example, in some embodiments charge-path resistor 231 may have a resistance of 0.1, 0.25, 0.5, 1.0, 1.5, 2, 4, or more Ohms, while discharge-path resistor 241 may have a resistance that is 2, 3, 4, 5, 10, or more times greater than the resistance of charge-path resistor 231.

Due to the absence of a blocking diode in discharge path 440, discharge path 440 may also pass a small charging current from driver circuit 102 to the gate of transistor 224 in parallel to charge path 230. The total charging current provided to the gate of transistor 224 may nonetheless still be predominated by charge path 230 due to the lower resistance value of charge-path resistor 231 relative to the resistance value of discharge-path resistor 241. Accordingly, the asymmetric impedance of charge path 230 and the discharge path 440 in switch circuit 425 may still be realized with the omission of a blocking diode in the discharge path 440. Such omission of a blocking diode may reduce the number of components used to implement the asymmetric impedance, thereby saving cost and chip space.

As also shown in FIG. 4, transistor driver system 400 may include drive path 404. Drive path 404 may be coupled to the output of driver circuit 102 and may pass drive signals for driving one or more instances of switch circuit 225 to the respective gate inputs 226 of switch circuits 225. For example, in some embodiments, drive path may include charge branch 330 and discharge branch 348 coupled in parallel to each other between the output of driver circuit 102 and the respective gate inputs 226 of one or more instances of switch circuit 225.

As described above, charge branch 330 may include charge-branch diode 332 coupled in series with charge-branch resistor 331, with the cathode of charge-branch diode 332 pointing toward the gate input 226 of switch circuit 225. Accordingly, charge branch 330 may provide a path through drive path 304 for a turn-on signal from driver circuit 102 that may charge the gate of transistor 224, thereby increasing the voltage at the gate of transistor 224, and driving transistor 224 in a conductive on-state.

Discharge branch 348 may include discharge-branch resistor 349. In some embodiment, the discharge-branch resistance of discharge-branch resistor 349 may be greater than the charge-branch resistance of charge-branch resistor 331. Accordingly, charge branch 330 and discharge branch 348 may have an asymmetric impedance. In some embodiments, the discharge-branch resistance of discharge-branch resistor 349 may be greater than the charge-branch resistance of charge-branch resistor 331 by a ratio of, for example, 2:1, 3:1, 4:1, 5:1, 10:1, or more. Due to the absence of a blocking diode in discharge branch 348, discharge branch 348 may also pass a small charging current from driver circuit 102 toward the gate of transistor 224 in parallel to charge branch 330. The total charging current passed through drive path 404 may nonetheless still be predominated by charge branch 330 due to the lower resistance value of charge-branch resistor 331 relative to the resistance value of discharge-branch resistor 349.

Although the embodiment of transistor driver system 400 illustrated in FIG. 4 includes drive path 404 and a plurality of switch circuits 425 each included within an integrated circuit package 220, transistor driver system 400 may also be implemented with other configurations for the drive path and/or the plurality of switch circuits. For example, transistor driver system 400 may also be implemented with an alternative drive path such as drive path 304 described above with reference to FIG. 3 or drive path 104 described above with reference to FIG. 2.

In some embodiments, transistor 224 may be monolithically integrated with one or more components of charge path 230 and/or discharge path 440. For example, transistor 224, charge-path resistor 231, charge-path diode 232, and discharge-path resistor 241 may be monolithically integrated on the same semiconductor die included within integrated circuit package 220. In other embodiments, various components of charge path 230 and discharge path 440 may be included on one or more dies separate from the semiconductor die of transistor 224 but co-packaged with transistor 224 within integrated circuit package 220. Further example embodiments utilizing multi-die and/or multi-component co-packaging are described below with reference to FIG. 5A and FIG. 5B. In addition, examples of monolithic integration of resistors and diodes to monolithically form a charge path and/or a discharge path on the same semiconductor die as transistor 224 are described below with reference to FIGS. 6A-6D, 7A-7D, and 8A-8D.

FIG. 5A illustrates a schematic diagram of transistor driver system 500 in accordance with embodiments of the present disclosure. Transistor driver system 500 may be implemented in any suitable fashion according to the operation described in the present disclosure. As shown in FIG. 5, transistor driver system 500 may include driver circuit 102 and drive path 104 coupled to an output of driver circuit 102. Further, transistor driver system 500 may include at least one switch circuit 525 to be driven by driver circuit 102 via drive path 104. For example, driver circuit 102 may receive an input signal and in response to the input signal, provide an output signal for driving the respective transistors 224 of one or more instances of switch circuit 525 in a conductive on-state or in a non-conductive off-state.

Although the embodiment of transistor driver system 500 illustrated in FIG. 5 includes drive path 104 and a plurality of switch circuits 525 each included within an integrated circuit package 220, transistor driver system 500 may also be implemented with other configurations for the drive path and/or the plurality of switch circuits. For example, transistor driver system 500 may also be implemented with an alternative drive path such as drive path 404 described above with reference to FIG. 4, drive path 304 described above with reference to FIG. 3, or drive path 104 described above with reference to FIG. 2.

As shown in FIG. 5A, switch circuit 525 may include transistor 224. In some embodiments, transistor 224 may be a metal-oxide semiconductor field effect transistor (MOSFET) and may thus have a gate, a source, and a drain. In some embodiments, transistor 224 may specifically be, for example, an n-channel MOSFET (NMOS or NMOS transistor). Transistor 224 may be implemented with any suitable semiconductor material. In some embodiments, transistor 224 may be a silicon carbide transistor, or specifically an silicon carbide NMOS transistor. Transistor 224 may also be implemented with silicon, gallium nitride, or any other semiconductor material suitable to manufacture a power transistor.

Switch circuit 525 may also include charge path 235 coupled between gate input 226 of switch circuit 525 and the gate of transistor 224. As shown in FIG. 5A and described above, the gate input 226 of switch circuit 525 may be coupled to gate input 221 of integrated circuit package 220, where inductor 222 represents the parasitic inductance of such coupling, for example through bond wires or other intra-package routing. Thus, charge path 235 may also be referred to as a charge path coupled between gate input 221 of integrated circuit package 220 and the gate of transistor 224. In addition, switch circuit 525 may include a discharge path 245 coupled in parallel to charge path 235. As shown in FIG. 5, discharge path 245 may be coupled between gate input 226 of switch circuit 525 and the gate of transistor 224. Discharge path 245 may also be referred to as a discharge path coupled between gate input 221 of integrated circuit package 220 and the gate of transistor 224. As described below, this charge path 235 and discharge path 245 may have an asymmetric impedance.

In some embodiments, charge path 235 may include charge-path diode 232 coupled in series with charge-path resistor 231. For example, as shown in FIG. 5A, charge-path diode 232 may have an anode coupled to gate input 226 and a cathode coupled to a first terminal of charge-path resistor 231, which in turn may have a second terminal coupled to the gate of transistor 224. Accordingly, charge path 235 may provide a path for a turn-on signal from driver circuit 102 to charge the gate of transistor 224, thereby increasing the voltage at the gate of transistor 224, and driving transistor 224 in a conductive on-state. Charge-path diode 232 may however block any discharge current flowing away from the gate of transistor 224 through charge path 235. Such discharge current may instead pass through discharge path 245 as described below.

In some embodiments, discharge path 245 may include discharge-path diode 242 coupled in series with discharge-path resistor 241. For example, as shown in FIG. 5A, discharge-path diode 242 may have a cathode coupled to gate input 226 and an anode coupled to a first terminal of discharge-path resistor, which in turn may have a second terminal coupled to the gate of transistor 224. Accordingly, discharge path 245 may provide a path for a turn-off signal from driver circuit 102 to discharge the gate of transistor 224, thereby decreasing the voltage at the gate of transistor 224, and driving transistor 224 in a non-conductive off-state. Discharge-path diode 242 may however block any charge current flowing toward the gate of transistor 224 through discharge path 245. Such charge current may instead pass through charge path 235 as described above.

The discharge-path resistance of discharge-path resistor 241 may be greater than the charge-path resistance of charge-path resistor 231. Accordingly, charge path 235 and discharge path 245 may have an asymmetric impedance. In some embodiments, the discharge-path resistance of discharge-path resistor 241 may be greater than the charge-path resistance of charge-path resistor 231 by a ratio of, for example, 2:1, 3:1, 4:1, 5:1, 10:1, or more. For example, in some embodiments charge-path resistor 231 may have a resistance of 0.1, 0.25, 0.5, 1.0, 1.5, 2, 4, or more Ohms, while discharge-path resistor 241 may have a resistance that is 2, 3, 4, 5, 10, or more times greater than charge-path resistor 231. Further, in some embodiments, drive-path resistor 106 of drive path 104 may have a greater resistance that charge-path resistor 231 and/or discharge-path resistor 241.

The asymmetric impedance of charge path 235 and discharge path 245 may provide multiple benefits, including reducing or eliminating potentially harmful oscillations and also reducing switching losses. As described above, internal parasitic inductance (represented by inductor 222) and internal parasitic gate capacitance of transistor 224 may form an LC-tank with other circuitry, such as another parallel instance of switch circuit 525, susceptible to oscillations under certain conditions. The larger resistance of discharge-path resistor 241 may provide larger dampening for any such oscillations, thereby reducing or eliminating such oscillations and/or negative effects thereof. Further, the smaller resistance of charge-path resistor 231 may reduce switching losses. For example, resistance in the charge and/or discharge path of the gate of transistor 224 may contribute to switching losses, that is the energy required to turn transistor 224 on and off. Given the Miller effect of the parasitic gate-to-drain capacitance of transistors such as transistor 224, the switching loss during the turn-on transition may be larger than the switching loss during the turn-off transition. Thus, by keeping the resistance of charge-path resistor 231 smaller than the resistance of discharge-path resistor 241, switching losses may be reduced.

In some embodiments, the schematic configuration of charge path 235 and discharge path 245 may help facilitate the monolithic integration and/or co-packaging of components of switch circuit 525 within integrated circuit package 220. For example, in some embodiments, charge-path diode 232 and discharge-path diode may be implemented on one or more discrete die separate from the semiconductor die on which transistor 224 may be implemented. Meanwhile, charge-path resistor 231 and discharge-path resistor 241 may be monolithically integrated on the same semiconductor die as transistor 224. The two or more die used to form switch circuit 525 may then be co-packaged together within integrated circuit package 220. Such multi-die and/or multi-component co-packaging is described in further detail below with reference to FIG. 5B.

FIG. 5B illustrates a perspective view of a multi-die switch circuit in accordance with embodiments of the present disclosure. Specifically, FIG. 5B illustrates a progression as different die forming the components of a switch circuit are packaged together within integrated circuit package 220.

As shown in FIG. 5B, transistor 224 may be implemented on semiconductor die 501. In some embodiments, transistor 224 may be a silicon carbide MOSFET transistor and semiconductor die 501 may be a silicon carbide die including, for example, a silicon carbide substrate and various metal routing layers and interlayer dielectrics placed on the surface of the silicon carbide substrate to provide various contacts and routing for terminals of the MOSFET transistor. In addition, charge-path resistor 231 and discharge-path resistor 241 may be monolithically integrated on the same semiconductor die 501 as transistor 224. For example, charge-path resistor 231 and discharge-path resistor 241 may be implanted as polysilicon resistors located on a polysilicon layer within an interlayer dielectric above the surface of the silicon carbide substrate. Although not shown in FIG. 5B, each of charge-path resistor 231 and discharge-path resistor 241 may have first terminals coupled to the gate of transistor 224 and second terminals to be respectively coupled charge-path diode 232 and discharge-path diode 242.

As further shown in FIG. 5B, charge-path diode 232 may be implemented on second die 502 and discharge-path diode 242 may be implemented on third die 503. Second die 502 and third die 503 may be stacked on semiconductor die 501 and coupled such that charge-path diode 232 is coupled in series with charge-path resistor 231 and discharge-path diode 242 is coupled in series with discharge-path resistor 241. Charge-path diode 232 and discharge-path diode 242 may then be coupled to the gate input 221 of integrated circuit package 220 as shown with reference back to FIG. 5A. Although the embodiment shown in FIG. 5B illustrates each of charge-path diode 232 and discharge-path diode 242 coupling to a lead frame of integrated circuit package 220, in some embodiments, the anode of charge-path diode 232 and the cathode of discharge-path diode 242 may also be coupled together and/or to the gate input 226 of switch circuit 525, which may in turn be coupled to the gate input 221 of integrated circuit package 220 as shown in FIG. 5A.

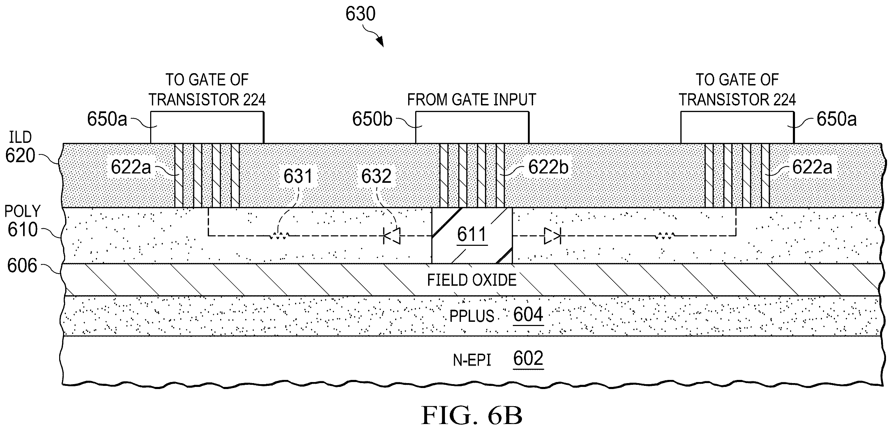

FIG. 6A illustrates a top layout view of charge path 630 for a gate of a transistor in accordance with embodiments of the present disclosure. FIG. 6B illustrates a side cross-section view of charge path 630 for a gate of a transistor in accordance with embodiments of the present disclosure. Charge path 630 illustrated in FIG. 6A and FIG. 6B may illustrate an embodiment, for example, of the physical implementation of charge path 230 described above with reference to FIG. 2. For example, the charge-path resistor 231 and discharge-path resistor 241 may be polysilicon resistors such as the polysilicon resistors described herein. Further, charge-path diode 232 and discharge-path diode 242 may be polysilicon p-n diodes such as the polysilicon p-n diodes also described herein.

As shown in FIGS. 6A and 6B collectively, charge path 630 may include a first n-doped region of polysilicon 610. The first n-doped region of polysilicon 610 may be located for example above an N-type epitaxial region 602. In some embodiments, a transistor such as transistor 224 may be implemented in the N-type epitaxial region 602 in a different area of the semiconductor die than is shown in FIG. 6A and FIG. 6B. A further heavy p-type doped region 604 and field oxide region 606 may separate the first n-doped region of polysilicon 610 from the N-type epitaxial region 602 as shown in FIG. 6B. In some embodiments, the field oxide may be formed with silicon dioxide, for example, or any other dielectric material suitable to electrically insulate the first n-doped region of polysilicon 610. In addition, an interlayer dielectric 620 may be formed over the first n-doped region of polysilicon 610. Interlayer dielectric 620 may be formed with silicon dioxide, for example, or any other dielectric material suitable to electrically insulate the first n-doped region of polysilicon 610.

A p-type doping may be added to form a first p-doped region of polysilicon 611 within an area of the first n-doped region of polysilicon 610. The p-n junction between the first p-doped region of polysilicon 611 and the first n-doped region of polysilicon 610 may form a polysilicon p-n diode as illustrated in FIG. 6B by polysilicon p-n diode 632. Further, the path along the first n-doped region of polysilicon 610 may form a polysilicon resistor 631. For example, as shown in FIG. 6B, vias 622b may couple first p-doped region of polysilicon 611 (the anode of polysilicon p-n diode 632) to metal routing 650b which couples to the gate input of the switch circuit. Meanwhile, vias 622a may couple first n-doped region of polysilicon 610 to metal routing 650a, which couples to the gate of transistor 224. The resistivity of the path of first n-doped region of polysilicon 610 from first p-doped region of polysilicon 611 to vias 622a may form polysilicon resistor 631. Thus, a charge-path resistor is formed by a first n-doped region of polysilicon 610 that also forms a cathode of the charge-path diode. The resistance value of the polysilicon resistor 631 that forms the charge-path resistor may be a function of multiple factors, including for example the doping level and thus the baseline resistivity per unit area of first n-doped region of polysilicon 610. The resistance value of the polysilicon resistor 631 that forms the charge-path resistor may also be a function of the length 643 and width 644 of the path from first p-doped region of polysilicon 611, through first n-doped region of polysilicon 610, and to vias 622a. Further, to the extent that multiple parallel paths to multiple sets of vias 622a are present as shown in FIG. 6A and FIG. 6B, the resistance value may depend on the effective width and length of the different parallel paths considered together collectively.

Although FIGS. 6A and 6B illustrate an embodiment of charge path 630 whereby polysilicon p-n diode 632 serves as a charge-path diode and polysilicon resistor 631 serves as a charge-path resistor, some embodiments may include one or more polysilicon resistors monolithically integrated on the same die as transistor 224, but with a charge-path diode and/or discharge-path diode implemented on separate co-packaged dies, such as described above with reference to FIGS. 5A and 5B. For such embodiments, the p-type doping used to form first p-doped region of polysilicon 611 may be omitted and vias 622b may be coupled directly to first n-doped region of polysilicon 610. Accordingly, for such embodiments, the charge-path diode formed by polysilicon p-n diode 632 may be omitted while the charge-path resistor formed by polysilicon resistor 631 remains.

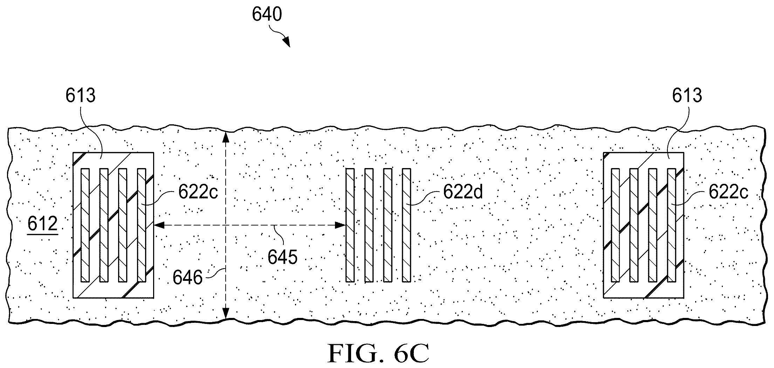

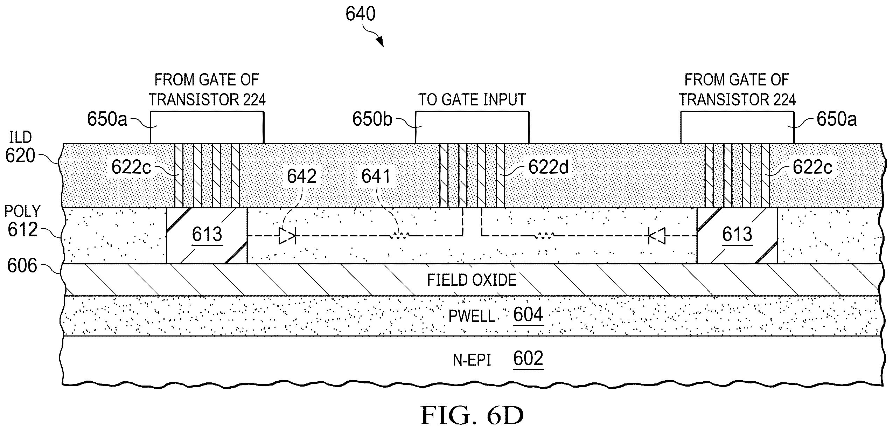

FIG. 6C illustrates a top layout view of discharge path 640 for a gate of a transistor in accordance with embodiments of the present disclosure. FIG. 6D illustrates a side cross-section view of discharge path 640 for a gate of a transistor in accordance with embodiments of the present disclosure. Discharge path 640 illustrated in FIG. 6C and FIG. 6D may illustrate an embodiment, for example, of the physical implementation of discharge path 240 described above with reference to FIG. 2. For example, charge-path resistor 231 and discharge-path resistor 241 may be polysilicon resistors such as the polysilicon resistors described directly herein. Further, charge-path diode 232 and discharge-path diode 242 may be polysilicon p-n diodes such as the polysilicon p-n diodes also described herein.

As shown in FIG. 6C and 6D collectively, discharge path 640 may include a second n-doped region of polysilicon 612. The second n-doped region of polysilicon 612 may be located on a different area of the semiconductor die than for example the first n-doped region of polysilicon 610 so as to keep the elements of charge path 630 separate from the elements of discharge path 640. A p-type doping may be added to form a second p-doped region of polysilicon 613 within one or more areas of the second n-doped region of polysilicon 611. The p-n junction between the second p-doped region of polysilicon 613 and the second n-doped region of polysilicon 612 may form a polysilicon p-n diode as illustrated in FIG. 6D by polysilicon p-n diode 642. Further, the path along the second n-doped region of polysilicon 612 may form a polysilicon resistor 641. For example, as shown in FIG. 6D, vias 622c may couple second p-doped region of polysilicon 613 (the anode of polysilicon p-n diode 642) to metal routing 650a which couples to the gate of transistor 224. Meanwhile, vias 622d may couple second n-doped region of polysilicon 612 to metal routing 650b, which couples to the gate input of the switch circuit as a whole. The resistivity of the path of second n-doped region of polysilicon 612 from second p-doped region of polysilicon 613 to vias 622d may form polysilicon resistor 641. Thus, a discharge-path resistor is formed by the second n-doped region of polysilicon 612 that also forms the cathode of the discharge-path diode. The resistance value of the polysilicon resistor 641 that forms the discharge-path resistor may be a function of multiple factors, including for example the doping level and thus the baseline resistivity per unit area of second n-doped region of polysilicon 612. The resistance value of the polysilicon resistor 641 that forms the discharge-path resistor may also be a function of the length 645 and width 646 of the path from second p-doped region of polysilicon 613, through second n-doped region of polysilicon 612, and to vias 622d. Further, to the extent that multiple parallel paths are present as shown in FIG. 6C and FIG. 6D, the resistance value may depend on the effective width and length of the different parallel paths considered together collectively.

In some embodiments, the resistance of polysilicon resistor 641 that forms the discharge-path resistor of discharge path 640 shown in FIGS. 6C and 6D may be greater than the resistance of polysilicon resistor 631 that forms the charge-path resistor of charge path 630. For example, second n-doped region of polysilicon 612 may have a lighter doping than first n-doped region of polysilicon 610, thus providing a larger baseline resistance per unit area for forming polysilicon resistor 641 of discharge path 640. In addition or in the alternative, second n-doped region of polysilicon 612 may have a longer length 645 and/or shorter width 646 than the respective length 643 and width 644 of first n-doped region of polysilicon 610, thereby causing polysilicon resistor 641 of discharge path 640 to have a larger resistance than polysilicon resistor 631 of charge path 630.

Although FIG. 6C and 6D illustrate an embodiment of discharge path 640 whereby polysilicon p-n diode 642 serves as a discharge-path diode and polysilicon resistor 641 serves as a discharge-path resistor, some embodiments may include one or more polysilicon resistors monolithically integrated on the same die as transistor 224, but with the discharge-path diode omitted (similar to the embodiments described above with reference to FIG. 4) or separately included on another co-packaged die (similar to the embodiments described above with reference to FIGS. 5A and 5B). For example, the p-type doping used to form second p-doped region of polysilicon 613 may be omitted. In such embodiments, the discharge-path diode may thus be omitted. Moreover, in such embodiments, vias 622c may be coupled directly to second n-doped region of polysilicon 612, and the discharge-path resistor formed by polysilicon resistor 641 may thus have a resistance based on the length and the width of the path from vias 622c, through the second n-doped region of polysilicon 612, and to vias 622d.

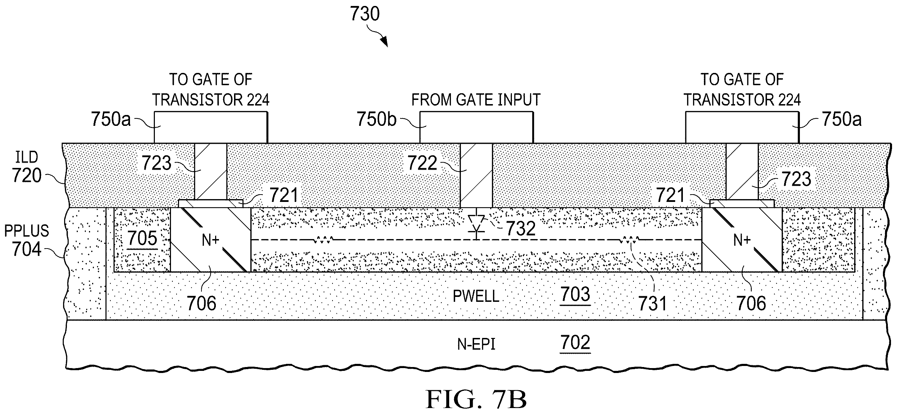

FIG. 7A illustrates a top layout view of charge path 730 for a gate of a transistor in accordance with embodiments of the present disclosure. FIG. 7B illustrates a side cross-section view of charge path 730 for a gate of a transistor in accordance with embodiments of the present disclosure. Charge path 730 illustrated in FIG. 7A and FIG. 7B may illustrate an embodiment, for example, of the physical implementation of charge path 230 described above with reference to FIG. 2. Further, charge-path diode 232 and discharge-path diode 242 may be Schottky didoes such as the Schottky diodes described below.

As shown in FIGS. 7A and 7B collectively, a first n-doped semiconductor region 705 may be formed within a p-type well 703, which may in turn be located within a n-type epitaxial region 702. In some embodiments, a transistor such as transistor 224 may be implemented in the n-type epitaxial region 702 in a different area of the semiconductor die than is shown in FIG. 7A and FIG. 7B. To help isolate the components of charge path 730 from the transistor and/or other components of the semiconductor die, the p-type well 703 may also be located laterally within heavy p-type doped region 704 as shown in FIG. 7B. Further, one or more heavy n-doped regions 706 may be formed within the first n-doped semiconductor region 705. In some embodiments, heavy n-doped regions 706 may have a higher doping concentration of n-type dopants than first n-doped semiconductor region 705. An interlayer dielectric 720 may be formed over the first n-doped semiconductor region 705 as well as the heavy n-doped regions 706. Interlayer dielectric 720 may be formed with silicon dioxide, for example, or any other dielectric material suitable to electrically insulate underlying semiconductor regions.

As shown in FIG. 7B, via 722 may couple first n-doped semiconductor region 705 to metal routing 750b, which may be coupled to the gate input of the switch circuit as a whole. Further, contact 721 and via 723 may couple heavy n-doped regions 706 to metal routing 750a, which may be coupled to the gate of the transistor such as transistor 224. Contact 721 may include, for example, a silicide layer that may improve the conductivity between via 723 and heavy n-doped regions 706. Contact 721 may thus help form a low-resistance coupling between heavy n-doped regions 706 and via 723. In some embodiments, vias 722 and 723 may be formed by a conductive material such as a metal or a metal alloy. For example, vias 722 and 723 may include one or more of aluminum, copper, tungsten, and/or alloys thereof.

The metal-to-semiconductor interface of via 722 and first n-doped semiconductor region 705 may form a Schottky diode, as illustrated in FIG. 7B by charge-path diode 732. For example, first n-doped semiconductor region 705 may have a light doping level such that a Schottky barrier is formed at the junction between the metal of via 722 and the semiconductor material of first n-doped semiconductor region 705. Further, the path from via 722, through the first n-doped semiconductor region 705, and to heavy n-doped regions 706, may form a charge-path resistor 731. Accordingly, charge-path resistor 731 may be formed in the first n-doped semiconductor region 705 that also forms a cathode of charge-path diode 732.

The resistance of charge-path resistor 731 may be a function of multiple factors. For example, the resistance of charge-path resistor 731 may include the resistance through both first n-doped semiconductor region 705 and heavy n-doped regions 706. In some embodiments however, the doping level of heavy n-doped regions 706 may be greater than the doping level of first n-doped semiconductor region 705, thus causing the resistance of charge-path resistor 731 to be predominated by the resistance of the path through first n-doped semiconductor region 705. The resistance value of charge-path resistor 731 may also be a function of the length 743 and width 744 of the path from via 722, through the first n-doped semiconductor region 705, and to heavy n-doped regions 706. Further, to the extent that multiple parallel paths through first n-doped semiconductor region 705 are present as shown in FIG. 7A and FIG. 7B, the resistance of charge-path resistor 731 may depend on the effective width and length of the different parallel paths considered together collectively.

Although FIGS. 7A and 7B illustrate an embodiment of charge path 730 charge-path diode 732 and charge-path resistor 731, some embodiments may include one or more resistors monolithically integrated on the same die as transistor 224, but with a charge-path diode and/or a discharge-path diode implemented on separate co-packaged dies, such as described above with reference to FIGS. 5A and 5B. For such embodiments, the contact 721 and heavy n-doped region 706 under via 723 may be duplicated under via 722, thereby preventing the formation of a Schottky diode at an interface of via 722 and first n-doped semiconductor region 705. Charge-path resistor 731 may remain and be defined by the resistance of the path through first n-doped semiconductor region 705 between heavy n-doped region 706 under via 723 and the additional heavy n-doped region under via 722.

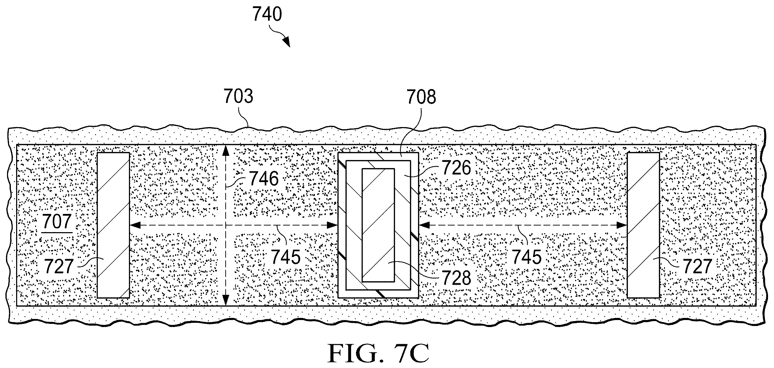

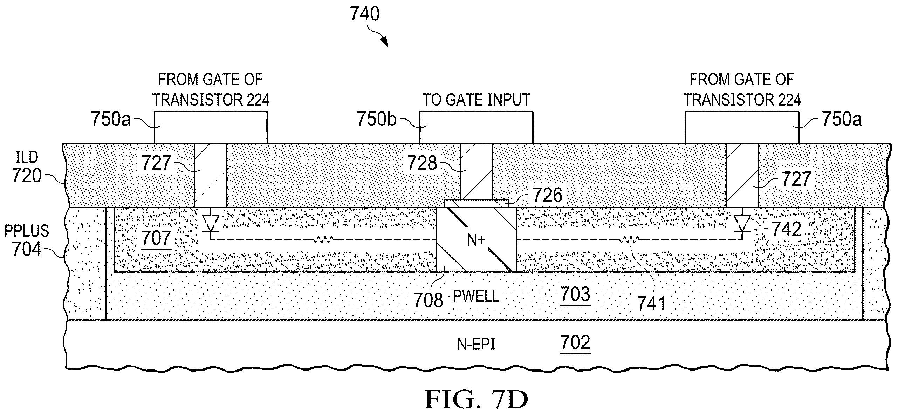

FIG. 7C illustrates a top layout view of discharge path 740 for a gate of a transistor in accordance with embodiments of the present disclosure. FIG. 7D illustrates a side cross-section view of discharge path 740 for a gate of a transistor in accordance with embodiments of the present disclosure. Discharge path 740 illustrated in FIG. 7C and FIG. 7D may illustrate an embodiment, for example, of the physical implementation of discharge path 240 described above with reference to FIG. 2. Further, charge-path diode 232 and discharge-path diode 242 may be Schottky diodes such as the Schottky diodes described below.

As shown in FIG. 7C and 7D collectively, a second n-doped semiconductor region 707 may be formed within a p-type well 703. Further, one or more heavy n-doped regions 708 may be formed within the second n-doped semiconductor region 707. In some embodiments, heavy n-doped regions 708 may have a higher doping concentration of n-type dopants than second n-doped semiconductor region 707.

As shown in FIG. 7D, one or more vias 727 may couple second n-doped semiconductor region 707 to metal routing 750a, which may be coupled to the gate of transistor 224. Further, contact 726 and via 728 may couple heavy n-doped region 708 to metal routing 750b, which may be coupled to the gate input of the switch circuit as a whole. Contact 726 may include, for example, a silicide layer that may improve the conductivity between via 728 and heavy n-doped region 708. Contact 726 may thus help form a low-resistance coupling between heavy n-doped region 708 and via 728. In some embodiments, vias 727 and 728 may be formed by a conductive material such as a metal or a metal alloy. For example, vias 727 and 728 may include one or more of aluminum, copper, tungsten, and/or alloys thereof.

The metal-to-semiconductor interface of via 727 and second n-doped semiconductor region 707 may form a Schottky diode, as illustrated in FIG. 7D by discharge-path diode 742. For example, second n-doped semiconductor region 707 may have a light doping level such that a Schottky barrier is formed at the junction between the metal of via 727 and the semiconductor material of second n-doped semiconductor region 707. Further, the path from via 727, through the second n-doped semiconductor region 707, and to heavy n-doped region 708, may form discharge-path resistor 741. Accordingly, discharge-path resistor 741 may be formed in the second n-doped semiconductor region 707 that also forms a cathode of the discharge-path diode 742.

The resistance of discharge-path resistor 741 may be a function of multiple factors. For example, the resistance of discharge-path resistor 741 may include the resistance through both second n-doped semiconductor region 707 and heavy n-doped region 708. In some embodiments however, the doping level of heavy n-doped regions 708 may be greater than the doping level of second n-doped semiconductor region 707, thus causing the resistance of discharge-path resistor 741 to be predominated by the resistance of the path through second n-doped semiconductor region 707. The resistance value of discharge-path resistor 741 may also be a function of the length 745 and width 746 of the path from via 727, through the second n-doped semiconductor region 707, and to heavy n-doped region 708. Further, to the extent that multiple parallel paths through second n-doped semiconductor region 707 are present as shown in FIG. 7C and FIG. 7D, the resistance of discharge-path resistor 741 may depend on the effective width and length of the different parallel paths considered together collectively.

In some embodiments, the resistance of discharge-path resistor 741 of discharge path 740 shown in FIGS. 7C and 7D may be greater than the resistance of charge-path resistor 731 of charge path 730 shown in FIGS. 7A and 7B. For example, second n-doped semiconductor region 707 may have a longer length 745 and/or shorter width 746 than the respective length 743 and width 744 of first n-doped semiconductor region 705, thereby causing discharge-path resistor 741 of discharge path 740 to have a larger resistance than charge-path resistor 731 of charge path 730.

Although FIG. 7C and 7D illustrate an embodiment of discharge path 740 including discharge-path diode 742 and discharge-path resistor 741, some embodiments may include a monolithically integrated discharge-path resistor, but with the discharge-path diode omitted (similar to the embodiments described above with reference to FIG. 4) or separately included on another co-packaged die (similar to the embodiments described above with reference to FIGS. 5A and 5B). For such embodiments, the contact 726 and heavy n-doped region 708 under via 728 may be duplicated under each instance of via 727, thereby preventing the formation of a Schottky diode at an interface of via 727 and second n-doped semiconductor region 707. Discharge-path resistor 741 may remain and be defined by the resistance of the path through second n-doped semiconductor region 707 between heavy n-doped region 708 under via 728 and the additional heavy n-doped region under via 727.

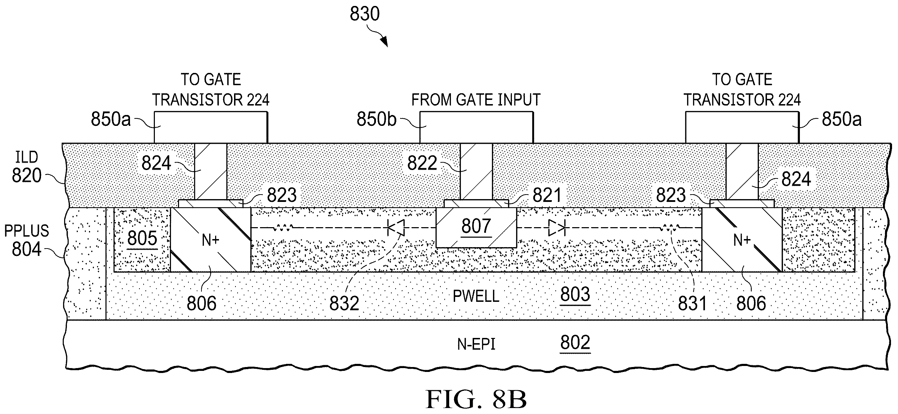

FIG. 8A illustrates a top layout view of charge path 830 for a gate of a transistor in accordance with embodiments of the present disclosure. FIG. 8B illustrates a side cross-section view of charge path 830 for a gate of a transistor in accordance with embodiments of the present disclosure. Charge path 830 illustrated in FIG. 8A and FIG. 8B may illustrate an embodiment, for example, of the physical implementation of charge path 230 described above with reference to FIG. 2. Further, charge-path diode 232 may be a p-n semiconductor diode such as the p-n semiconductor diodes described below.

As shown in FIGS. 8A and 8B collectively, a first n-doped semiconductor region 805 may be formed within a p-type well 803, which may in turn be located within a n-type epitaxial region 802. In some embodiments, a transistor such as transistor 224 may be implemented in the n-type epitaxial region 802 in a different area of the semiconductor die than is shown in FIG. 8A and FIG. 8B. To help isolate the components of charge path 830 from the transistor and/or other components of the semiconductor die, the p-type well 803 may also be located laterally within heavy p-type doped region 804 as shown in FIG. 8B. A p-doped region 807 may be formed within the first n-doped semiconductor region 805. Further, one or more heavy n-doped regions 806 may be formed within the first n-doped semiconductor region 805. In some embodiments, heavy n-doped regions 806 may have a higher doping concentration of n-type dopants than first n-doped semiconductor region 805. An interlayer dielectric 820 may be formed over the first n-doped semiconductor region 805, as well as the heavy n-doped regions 806 and p-doped region 807. Interlayer dielectric 820 may be formed with silicon dioxide, for example, or any other dielectric material suitable to electrically insulate underlying semiconductor regions.

As shown in FIG. 8B, via 822 and contact 821 may couple p-doped region 807 to metal routing 850b, which may be coupled to the gate input of the switch circuit as a whole. Further, via 824 and contact 823 may couple heavy n-doped regions 806 to metal routing 850a, which may be coupled to the gate of the transistor such as transistor 224. Contacts 821 and 823 may include, for example, a silicide layer that may improve the conductivity between their respective corresponding vias and the underlying semiconductor regions. In some embodiments, vias 822 and 824 may be formed by a conductive material such as a metal or a metal alloy. For example, vias 822 and 824 may include one or more of aluminum, copper, tungsten, and/or alloys thereof.

The p-n junction at the interface of p-doped region 807 and first n-doped semiconductor region 805 may form a p-n semiconductor diode, as illustrated in FIG. 8B by charge-path diode 832. Further, the path from p-doped region 807, through the first n-doped semiconductor region 805, and to heavy n-doped regions 806, may form a charge-path resistor 831. Accordingly, charge-path resistor 831 may be formed in the first n-doped semiconductor region 805 that also forms a cathode of charge-path diode 832.

The resistance of charge-path resistor 831 may be a function of multiple factors. For example, the resistance of charge-path resistor 831 may include the resistance through both first n-doped semiconductor region 805 and heavy n-doped regions 806. In some embodiments however, the doping level of heavy n-doped regions 806 may be greater than the doping level of first n-doped semiconductor region 805, thus causing the resistance of charge-path resistor 831 to be predominated by the resistance of the path through first n-doped semiconductor region 805. The resistance value of charge-path resistor 831 may also be a function of the length 843 and width 844 of the path from p-doped region 807, through the first n-doped semiconductor region 805, and to heavy n-doped regions 806. Further, to the extent that multiple parallel paths through first n-doped semiconductor region 805 are present as shown in FIG. 8A and FIG. 8B, the resistance of charge-path resistor 831 may depend on the effective width and length of the different parallel paths considered together collectively.

Although FIGS. 8A and 8B illustrate an embodiment of charge path 830 with charge-path diode 832 and charge-path resistor 831, some embodiments may include one or more resistors monolithically integrated on the same die as transistor 224, but with a charge-path diode and/or a discharge-path diode implemented on separate co-packaged dies, such as described above with reference to FIGS. 5A and 5B. For such embodiments, the p-doped region 807 may be replaced by additional heavy n-doped regions under via 822 and contacts 821 in order to omit the formation of the p-n semiconductor diode represented as charge-path diode 832 in FIG. 8B. Charge-path resistor 831 may remain and be defined by the resistance of the path through first n-doped semiconductor region 805.

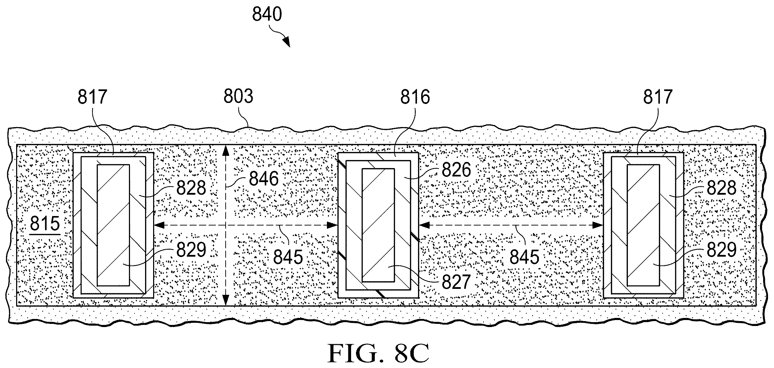

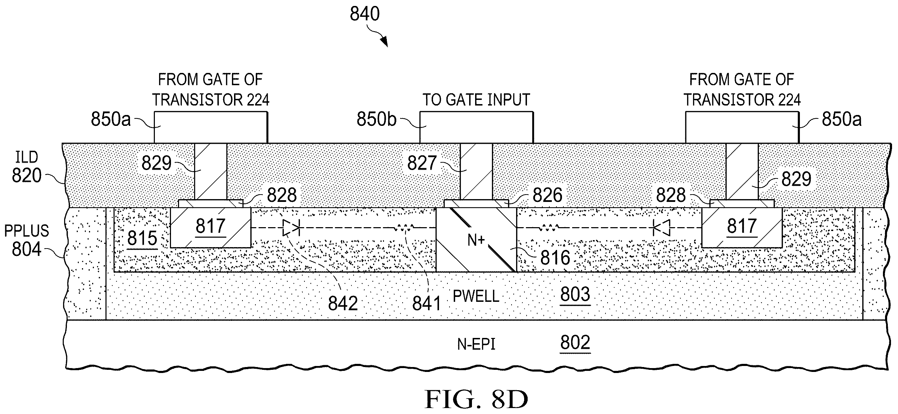

FIG. 8C illustrates a top layout view of discharge path 840 for a gate of a transistor in accordance with embodiments of the present disclosure. FIG. 8D illustrates a side cross-section view of discharge path 840 for a gate of a transistor in accordance with embodiments of the present disclosure. Discharge path 840 illustrated in FIG. 8C and FIG. 8D may illustrate an embodiment, for example, of the physical implementation of discharge path 240 described above with reference to FIG. 2. Further, discharge-path diode 242 may be a p-n semiconductor diode such as the p-n semiconductor diodes described below.

As shown in FIG. 8C and 8D collectively, a second n-doped semiconductor region 815 may be formed within p-type well 803, which may in turn be located within a n-type epitaxial region 802. To help isolate the components of charge path 830 from the transistor and/or other components of the semiconductor die, the p-type well 803 may also be located laterally within heavy p-type doped region 804 as shown in FIG. 8D. One or more p-doped regions 817 may be formed within the second n-doped semiconductor region 815. Further, a heavy n-doped region 816 may be formed within the second n-doped semiconductor region 815. In some embodiments, heavy n-doped region 816 may have a higher doping concentration of n-type dopants than second n-doped semiconductor region 815. Interlayer dielectric 820 may be formed over the second n-doped semiconductor region 815, as well as the heavy n-doped region 816 and the one or more p-doped regions 817. Interlayer dielectric 820 may be formed with silicon dioxide, for example, or any other dielectric material suitable to electrically insulate underlying semiconductor regions.

As shown in FIG. 8D, vias 829 and contacts 828 may couple the one or more p-doped regions 817 to metal routing 850a, which may be coupled to the gate of the transistor such as transistor 224. Further, via 827 and contact 826 may couple heavy n-doped region 816 to metal routing 850b, which may be coupled to the gate input of the switch circuit as a whole. Contacts 826 and 828 may include, for example, a silicide layer that may improve the conductivity between their respective corresponding vias and the underlying semiconductor regions. In some embodiments, vias 827 and 829 may be formed by a conductive material such as a metal or a metal alloy. For example, vias 827 and 829 may include one or more of aluminum, copper, tungsten, and/or alloys thereof.

The p-n junction at the interface of each p-doped region 817 and second n-doped semiconductor region 815 may form a p-n semiconductor diode, as illustrated in FIG. 8D by discharge-path diode 842. Further, the path from p-doped region 817, through the second n-doped semiconductor region 815, and to heavy n-doped region 816, may form a discharge-path resistor 841. Accordingly, discharge-path resistor 841 may be formed in the second n-doped semiconductor region 815 that also forms the cathode of discharge-path diode 842.

The resistance of discharge-path resistor 841 may be a function of multiple factors. For example, the resistance of discharge-path resistor 841 may include the resistance through both second n-doped semiconductor region 815 and heavy n-doped region 816. In some embodiments however, the doping level of heavy n-doped region 816 may be greater than the doping level of second n-doped semiconductor region 815, thus causing the resistance of discharge-path resistor 841 to be predominated by the resistance of the path through second n-doped semiconductor region 815. The resistance value of discharge-path resistor 841 may also be a function of the length 845 and width 846 of the path from p-doped region 817, through the second n-doped semiconductor region 815, and to heavy n-doped region 816. Further, to the extent that multiple parallel paths through second n-doped semiconductor region 815 are present as shown in FIG. 8C and FIG. 8D, the resistance of discharge-path resistor 841 may depend on the effective width and length of the different parallel paths considered together collectively.

In some embodiments, the resistance of discharge-path resistor 841 of discharge path 840 shown in FIGS. 8C and 8D may be greater than the resistance of charge-path resistor 831 of charge path 830 shown in FIGS. 8A and 8B. For example, second n-doped semiconductor region 815 may have a longer length 845 and/or shorter width 846 than the respective length 843 and width 844 of first n-doped semiconductor region 805, thereby causing discharge-path resistor 841 of discharge path 840 to have a larger resistance than charge-path resistor 831 of charge path 830.

Although FIG. 8C and 8D illustrate an embodiment of discharge path 840 including discharge-path diode 842 and discharge-path resistor 841, some embodiments may include a discharge-path resistor monolithically integrated with transistor 224, but with the discharge-path diode omitted (similar to the embodiments described above with reference to FIG. 4) or separately included on another co-packaged die (similar to the embodiments described above with reference to FIGS. 5A and 5B). For such embodiments, the one or more p-doped regions 817 may be replaced by additional heavy n-doped regions under vias 829 and contacts 828 in order to omit the formation of the p-n semiconductor diode represented as discharge-path diode 842 in FIG. 8D. Discharge-path resistor 841 may remain and be defined by the resistance of the path through second n-doped semiconductor region 815.

Although examples have been described above, other modifications and variations may be made from this disclosure without departing from the spirit and scope of these examples. The above descriptions of various embodiments illustrate the principles of the invention. Numerous variations and modifications will become apparent to those skilled in the art based on the above disclosure. The following claims are intended to embrace all such variations and modifications.

## Claims

1. A switch circuit comprising:
a transistor including a gate, a source, and a drain, the transistor included within an integrated circuit package;
a charge path coupled between a gate input of the integrated circuit package and the gate of the transistor; and
a discharge path coupled between the gate input of the integrated circuit package and the gate of the transistor; and
wherein the charge path and the discharge path have an asymmetric impedance.

2. The switch circuit of claim 1, wherein the transistor is a silicon carbide transistor.

3. The switch circuit of claim 1, wherein the charge path includes a charge-path diode coupled in series with a charge-path resistor.

4. The switch circuit of claim 3, wherein the discharge path includes a discharge-path resistor.

5. The switch circuit of claim 4, wherein a discharge-path resistance of the discharge-path resistor is greater than a charge-path resistance of the charge-path resistor.

6. The switch circuit of claim 4, wherein the discharge path further includes a discharge-path diode coupled in series with the discharge-path resistor.

7. A driver system comprising:
a driver circuit;
a drive path coupled to an output of the driver circuit;
at least one switch circuit coupled to be driven by the driver circuit via the drive path, wherein each of the at least one switch circuit comprises:
a transistor including a gate, a source, and a drain, the transistor included within an integrated circuit package;
a charge path coupled between a gate input of the integrated circuit package and the gate of the transistor; and
a discharge path coupled between the gate input of the integrated circuit package and the gate of the transistor; and
wherein the charge path and the discharge path have an asymmetric impedance.

8. The driver system of claim 7, wherein the drive path includes a charge branch and a discharge branch coupled in parallel to each other.

9. The driver system of claim 8, wherein the charge branch includes a charge-branch diode coupled in series with a charge-branch resistor.

10. The driver system of claim 9, wherein the discharge branch includes a discharge-branch resistor.

11. The driver system of claim 10, wherein a discharge-branch resistance of the discharge-branch resistor is greater than a charge-branch resistance of the charge-branch resistor.

12. The driver system of claim 11, wherein the discharge branch further includes a discharge-branch diode coupled in series with the discharge-branch resistor.

13. The driver system of claim 7, wherein the charge path includes a charge-path diode coupled in series with a charge-path resistor.

14. The driver system of claim 13, wherein the discharge path includes a discharge-path resistor.

15. The driver system of claim 14, wherein a discharge-path resistance of the discharge-path resistor is greater than a charge-path resistance of the charge-path resistor.
